# FASCICULE DE BREVET EUROPEEN

(11) **EP 3 973 579 B1**
(45) Date de publication et mention de la délivrance du brevet: **26.04.2023**
(21) Numéro de dépôt: 20731535.9
(22) Date de dépôt: 29.04.2020
(51) Int. Cl.: H01L 33/16, H01L 33/32, H01L 33/02, H01L 33/24, H01L 33/14

(54) **DISPOSITIF OPTOELECTRONIQUE AVEC DIODES ELECTROLUMINESCENTES DONT UNE ZONE DOPEE INTEGRE UNE PORTION EXTERNE A BASE D'ALUMINIUM ET DE NITRURE DE GALIUM**
OPTOELEKTRONISCHE VORRICHTUNG MIT LEUCHTDIODEN, DEREN DOTIERTER BEREICH EIN ÄUSSERES SEGMENT BASIEREND AUF ALUMINIUM UND GALIUMNITRID ENTHÄLT
OPTOELECTRONIC DEVICE WITH LIGHT-EMITTING DIODES A DOPED REGION OF WHICH INCORPORATES AN EXTERNAL SEGMENT BASED ON ALUMINIUM AND GALLIUM NITRIDE

(30) Priorité: 20.05.2019 FR 1905257
(43) Date de publication de la demande: 30.03.2022
(73) Titulaire: Aledia, 38130 Echirolles (FR)
(72) Inventeur: TCHOULFIAN, Pierre, 38000 Grenoble (FR); AMSTATT, Benoît, 38000 Grenoble (FR)
(74) Mandataire: Germain Maureau
(86) Numéro de dépôt international: PCT/FR2020/050725
(87) Numéro de publication internationale: WO 2020/234521

(56) Documents cités:
- WO-A1-2017/042512
- WO-A1-2019/002720

## Description

### DOMAINE TECHNIQUE

La présente invention concerne un dispositif optoélectronique comportant un substrat ayant une face support et une pluralité de diodes électroluminescentes, chacune étant de forme filaire et formée sur la face support pour être allongée suivant un axe longitudinal sensiblement transversal à la face support du substrat, chaque diode électroluminescente comprenant une première zone dopée formée sur la face support par des éléments semiconducteurs dopés selon un premier type de dopage, une zone active formée dans un matériau actif et une seconde zone dopée formée par des éléments semiconducteurs dopés selon un deuxième type de dopage opposé au premier type de dopage.

L'invention concerne aussi un procédé de fabrication d'un dispositif optoélectronique comportant une pluralité de diodes électroluminescentes.

L'invention trouvera une application notamment dans les écrans d'affichage ou les systèmes de projection d'images ou d'éclairage.

### ETAT DE LA TECHNIQUE ANTERIEURE

De manière connue, un dispositif optoélectronique à diodes électroluminescentes permet d'effectuer la conversion d'un signal électrique en un rayonnement électromagnétique.

Il existe des dispositifs optoélectroniques, notamment des écrans d'affichage ou des dispositifs de projection d'images, comprenant des diodes électroluminescentes à base de matériaux semiconducteurs comprenant un empilement de couches semi-conductrices ou des éléments tridimensionnels comportant majoritairement au moins un élément du groupe III et un élément du groupe V, appelé par la suite composé III-V, notamment le nitrure de gallium (GaN), le nitrure de gallium et d'indium (InGaN) et le nitrure de gallium et d'aluminium (AIGaN).

Il est connu que chaque diode électroluminescente comprenne une couche active exploitant des puits quantiques comprise dans une jonction P-N. La jonction P-N comprend une portion semiconductrice dopée selon un premier type de dopage de type N et une portion semiconductrice dopée selon un deuxième type de dopage de type P.

L'une des difficultés dans les diodes électroluminescentes ayant une architecture tridimensionnelle de type coeur-coquille est que dans certaines conditions de croissance des éléments semiconducteurs constitutifs de la diode électroluminescente, comme par exemple le matériau d'un noyau filaire en nitrure de Galium ou GaN, des défauts au niveau de l'interface entre la diode électroluminescente et le substrat et au niveau des faces latérales de la diode électroluminescente sont malheureusement susceptibles d'apparaitre.

Ces défauts peuvent créer des fuites de courant néfastes pour les performances. Pour tenter de limiter ces risques, il a déjà été imaginé de réaliser des étapes supplémentaires pour isoler électriquement ces interfaces. A titre d'exemple, il a déjà été mis en oeuvre de déposer un matériau isolant au niveau de la bordure inférieure des diodes électroluminescentes après la croissance des diodes électroluminescentes ou bien en réalisant la diode électroluminescence en plusieurs étapes de croissance, en intercalant un nettoyage par exemple entre le coeur et la coquille.

Cependant, ces solutions impliquent des coûts non négligeables, souvent rédhibitoires, et susceptibles de créer d'autres défauts.

Une autre problématique repose sur le fait qu'il est nécessaire de parvenir à passiver les surfaces latérales des diodes électroluminescentes afin d'éviter leur oxydation ou limiter les fuites de courant par ces mêmes faces. Pour ce faire, il existe des techniques de passivation qui impliquent des étapes supplémentaires de procédé après la croissance des diodes électroluminescentes. Ceci n'est pas avantageux car cela contribue à la mise en oeuvre d'étapes supplémentaires, impliquant une augmentation des coûts de fabrication.

WO 2017/042512 A1 et WO 2019/002720 A1 divulguent des dispositifs optoélectroniques selon l'art antérieur.

### EXPOSE DE L'INVENTION

La présente invention a pour but de résoudre tout ou partie des problématiques présentées ci-avant.

Notamment, le but de l'invention est de proposer un dispositif optoélectronique du type précité qui réponde à au moins l'un des objectifs suivants :
- disposer d'un dispositif optoélectronique présentant le moins de défauts possible,
- disposer d'un dispositif optoélectronique ayant des fuites de courant au niveau de l'interface avec le substrat réduites ou nulles,
- disposer d'un dispositif optoélectronique ayant des fuites de courant au niveau des surfaces latérales réduites ou nulles,
- disposer d'un dispositif optoélectronique ayant des surfaces latérales au moins en partie passivées.

L'invention a également pour but de proposer un procédé de fabrication d'un dispositif optoélectronique, le procédé répondant à au moins l'un des objectifs suivants :
- avoir un nombre d'étapes pour la passivation d'au moins une partie des surfaces latérales réduit,
- avoir un nombre d'étapes pour la limitation des fuites de courant entre la diode électroluminescente et le substrat réduit,
- avoir un nombre d'étapes pour la limitation des fuites de courant provenant des surfaces latérales de la diode électroluminescente.

Ce but peut être atteint grâce à la fourniture d'un dispositif optoélectronique comportant un substrat ayant une face support et une pluralité de diodes électroluminescentes, chacune étant de forme filaire et formée sur la face support pour être allongée suivant un axe longitudinal sensiblement transversal à la face support du substrat, chaque diode électroluminescente comprenant une première zone dopée formée sur la face support par des éléments semi-conducteurs dopés selon un premier type de dopage, une zone active formée dans un matériau actif et une seconde zone dopée formée par des éléments semi-conducteurs dopés selon un deuxième type de dopage opposé au premier type de dopage, la première zone dopée étant constituée, sur tout ou partie de sa hauteur comptée suivant l'axe longitudinal, d'une première portion centrale sensiblement allongée suivant l'axe longitudinal formée dans un premier matériau à base de nitrure de gallium et d'une seconde portion externe formée dans un second matériau à base de nitrure de gallium et d'aluminium, la seconde portion étant constituée d'une première partie externe agencée latéralement autour de la première portion, tout ou partie de la première partie présentant une première concentration atomique moyenne en aluminium et d'une seconde partie inférieure agencée, suivant l'axe longitudinal, au moins entre la première partie de la seconde portion et le substrat, tout ou partie de la seconde partie présentant une deuxième concentration atomique moyenne en aluminium différente de la première concentration atomique moyenne et adaptée de sorte que la seconde partie est électriquement isolante.

Certains aspects préférés mais non limitatifs du dispositif optoélectronique sont les suivants.

Dans une mise en oeuvre du dispositif optoélectronique, le rapport entre la section de la première partie de la seconde portion, prise dans un plan perpendiculaire à l'axe longitudinale et positionné à une distance D par rapport à la face support, et la section de la première portion prise dans ledit plan, diminue lorsque la distance D augmente.

Dans une mise en oeuvre du dispositif optoélectronique, la première concentration atomique moyenne en aluminium correspond à des concentrations atomiques en aluminium ponctuelles prises en différents points de la première partie, les concentrations atomiques en aluminium ponctuelles pouvant varier dans le plan et selon la distance D.

Dans une mise en oeuvre du dispositif optoélectronique, la première concentration atomique moyenne en aluminium est comprise entre 0,5% et 15% et la deuxième concentration atomique moyenne en aluminium est comprise entre 20% et 50%.

Dans une mise en oeuvre du dispositif optoélectronique, ledit second matériau présente la deuxième concentration atomique moyenne au niveau de tout ou partie de son interface avec le premier matériau.

L'invention porte également sur un procédé de fabrication d'un dispositif optoélectronique comportant une pluralité de diodes électroluminescentes où chacune est de forme filaire allongée suivant un axe longitudinal A et comprend une première zone dopée formée sur la face support par des éléments semi-conducteurs dopés selon un premier type de dopage, une zone active formée dans un matériau actif et une seconde zone dopée formée par des éléments semi-conducteurs dopés selon un deuxième type de dopage opposé au premier type de dopage, le procédé comprenant les étapes suivantes :
a) fourniture d'un substrat ayant une face support, ledit axe longitudinal A étant destiné à être sensiblement transversal à ladite face support ;
b) formation, au niveau de ladite face support, d'une pluralité de zones chacune étant propice à la formation ultérieure d'au moins l'une des diodes électroluminescentes ;
c) formation de la première zone dopée de chaque diode électroluminescente au niveau de la zone correspondante, l'étape c) étant réalisée de telle manière qu'à l'issue de l'étape c), la première zone dopée est constituée, sur tout ou partie de sa hauteur comptée suivant l'axe longitudinal, d'une part d'une première portion centrale sensiblement allongée suivant l'axe longitudinal formée dans un premier matériau à base de nitrure de gallium, et d'autre part d'une seconde portion externe formée dans un second matériau à base de nitrure de gallium et d'aluminium, la seconde portion étant constituée d'une première partie externe agencée latéralement autour de la première portion, tout ou partie de la première partie présentant une première concentration atomique moyenne en aluminium et d'une seconde partie inférieure agencée, suivant l'axe longitudinal, entre au moins la première partie de la seconde portion et le substrat, tout ou partie de la seconde partie présentant une deuxième concentration atomique moyenne en aluminium différente de la première concentration atomique moyenne et adaptée de sorte que la seconde partie est électriquement isolante ;
d) formation de la zone active de chaque diode électroluminescente ;
e) formation de la seconde zone dopée de chaque diode électroluminescentes.

Certains aspects préférés mais non limitatifs du procédé sont les suivants.

Dans une mise en oeuvre du procédé, l'étape c) est réalisée par épitaxie en utilisant au moins en partie un premier gaz contenant du gallium et un deuxième gaz contenant de l'aluminium et un troisième gaz contenant du silane SiH₄.

Dans une mise en oeuvre du procédé, l'étape c) est réalisée dans une enceinte dans laquelle règne une température comprise entre 900 et 1100 °C.

Dans une mise en oeuvre du procédé, la première partie de la seconde portion, et la seconde partie de la seconde portion sont obtenues par une première phase de ségrégation lors de l'étape c).

Dans une mise en oeuvre du procédé, la première concentration atomique moyenne en aluminium est comprise entre 0,5% et 15% et la deuxième concentration atomique moyenne en aluminium est comprise entre 20% et 50%.

Dans une mise en oeuvre du procédé, l'étape c) comprend une deuxième phase de ségrégation de sorte qu'après la deuxième phase de ségrégation, le rapport entre la section de la première partie de la seconde portion, prise dans un plan perpendiculaire à l'axe longitudinal et positionné à une distance D par rapport à la face support, et la section de la première portion prise dans ledit plan, diminue lorsque la distance D augmente.

Dans une mise en oeuvre du procédé, la première concentration atomique moyenne en aluminium correspond à des concentrations atomiques en aluminium ponctuelles prises en différents points de la première partie, les concentrations atomiques en aluminium ponctuelles pouvant varier dans le plan et selon la distance D.

Dans une mise en oeuvre du procédé, la première phase de ségrégation et la deuxième phase de ségrégation sont réalisées au moins en partie en même temps.

Dans une mise en oeuvre du procédé, lors de l'étape c) le deuxième gaz contenant de l'aluminium est injecté avec un débit compris entre 1000 et 2000 sccm et le troisième gaz contenant du silane SiH₄ est injecté avec un débit compris entre 400 et 800 sccm.

Dans une mise en oeuvre du procédé, la première phase de ségrégation est réalisée de telle façon que le second matériau présente la deuxième concentration atomique moyenne au niveau de tout ou partie de son interface avec le premier matériau.

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
[Fig. 1] est une vue schématique vue de dessus représentant des zones propices à la croissance d'éléments de diodes électroluminescentes sur la face support d'un substrat.
[Fig. 2] est une vue schématique en coupe d'une partie d'une diode électroluminescente selon l'invention.
[Fig. 3] est une vue schématique en coupe d'une partie d'une diode électroluminescente selon l'invention.

### EXPOSE DETAILLE DE MODES DE REALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par souci de simplicité le nombre de diodes électroluminescentes représenté est limité mais dans les modes de réalisations décrits ci-après il n'y a pas de limitation quant à leur nombre. Par ailleurs, les différents modes de réalisation et variantes ne sont pas exclusifs les uns des autres et peuvent être combinés entre eux.

Dans le texte, sauf indication contraire, les termes « sensiblement », « environ » et « de l'ordre de » signifient « à 10 % près ».

L'invention porte en premier lieu sur un dispositif optoélectronique 10 comportant au moins une diode électroluminescente 12.

L'invention porte également sur un procédé de fabrication d'un tel dispositif optoélectronique 10.

Grâce au dispositif optoélectronique 12 selon l'invention, une application particulièrement visée est la fourniture d'un écran d'affichage d'images ou d'un dispositif de projection d'images.

Il est également clair que l'invention peut viser d'autres applications, en particulier la détection ou la mesure de radiations électromagnétiques ou encore des applications photovoltaïques.

Le dispositif optoélectronique 10 comporte un substrat 11 ayant une face support 110. Le substrat 11 est constitué par exemple par un empilement d'une couche monolithique (non représentée), d'une couche d'électrode inférieure (non représentée) qui peut être une couche de nucléation conductrice et d'une première couche d'isolation électrique (non représentée). Des ouvertures 14 propices à la croissance de premières portions 121 et de secondes portions 123 de diodes électroluminescentes 12 peuvent être formées à travers l'une des couches précédemment citées. L'homme du métier pourra se référer par exemple au brevet FR3053530 pour mettre en oeuvre un tel substrat 11 et de telles ouvertures 14.

La face support 110 du substrat 11 est constituée par exemple par la face libre de ladite première couche d'isolation électrique ou bien par la face libre des électrodes inférieures.

La couche monolithique peut être formée dans un matériau semiconducteur dopé ou non, par exemple de l'Al₂O₃ ou du silicium ou encore du germanium, et plus particulièrement du silicium monocristallin. Il peut aussi être formé en saphir voire en un matériau semiconducteur III-V, par exemple en GaN. Il peut alternativement s'agir d'un substrat de type silicium sur isolant ou « SOI » pour « Silicon On Insulator » selon la terminologie anglo-saxonne consacrée. Alternativement, la couche monolithique peut être formée dans un matériau électriquement isolant.

La couche de nucléation permet d'initier la croissance de premières portions 121 et des secondes portions 123 de diodes électroluminescentes. Elle peut être continue ou discontinue. Le matériau composant la couche de nucléation peut être un nitrure, un carbure ou un borure d'un métal de transition de la colonne IV, V ou VI du tableau périodique des éléments ou une combinaison de ces composés. A titre d'exemple, la couche de nucléation peut être en nitrure d'aluminium, en oxyde d'aluminium, en bore, en nitrure de bore, en titane, en nitrure de titane, en tantale, en nitrure de tantale, en hafnium, en nitrure d'hafnium, en niobium, en nitrure de niobium, en zirconium, en borure de zirconium, en nitrure de zirconium, en carbure de silicium, en nitrure et carbure de tantale, ou en nitrure de magnésium sous la forme MgₓN_{y}, où x est environ égal à 3 et y est environ égal à 2, par exemple du nitrure de magnésium sous la forme Mg₃N₂. La couche de nucléation peut être dopée et du même type de conductivité que celle des éléments semiconducteurs destinés à croître, et présenter une épaisseur par exemple comprise entre 1 nm et 200 nm, de préférence comprise entre 10 nm et 50 nm. La couche de nucléation peut être composée d'un alliage ou d'un empilement d'au moins un matériau mentionné dans la liste ci-dessus. La première couche d'isolation électrique peut comprendre une première couche isolante intermédiaire qui recouvre ladite couche d'électrode inférieure. Elle forme un masque de croissance autorisant la croissance par exemple épitaxiale des premières portions 121 et des secondes portions 123 de diodes électroluminescentes 12 à partir d'ouvertures 14 traversantes débouchant localement sur les surfaces de la couche d'électrode inférieure. La première couche d'isolation électrique participe également à assurer l'isolation électrique entre les couches de nucléation (non représentées) et les secondes électrodes supérieures (non représentées). La première couche isolante intermédiaire est réalisée dans au moins un matériau(x) diélectrique(s) tel(s) que, par exemple, un oxyde de silicium (par exemple SiO₂ ou SiON) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la première couche isolante intermédiaire peut être comprise entre 5 nm et 1 µm, de préférence comprise entre 20 nm et 500 nm, par exemple égale à 100 nm environ. La première couche de matériau d'isolation électrique peut comporter, en outre, une deuxième couche isolante électriquement intermédiaire (non représentée) qui recouvre les premières électrodes inférieures et participe à assurer l'isolation électrique entre les premières électrodes inférieures et les secondes électrodes supérieures. Ladite deuxième couche isolante électriquement intermédiaire peut recouvrir également le masque de croissance formé par la première couche isolante intermédiaire. La deuxième couche isolante intermédiaire peut être réalisée en un matériau diélectrique identique ou différent de celui du masque de croissance, tel que, par exemple, un oxyde de silicium (par exemple SiO₂) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la deuxième couche isolante intermédiaire peut être comprise entre 5 nm et 1 µm, de préférence comprise entre 20 nm et 500 nm, par exemple égale à 100 nm environ.

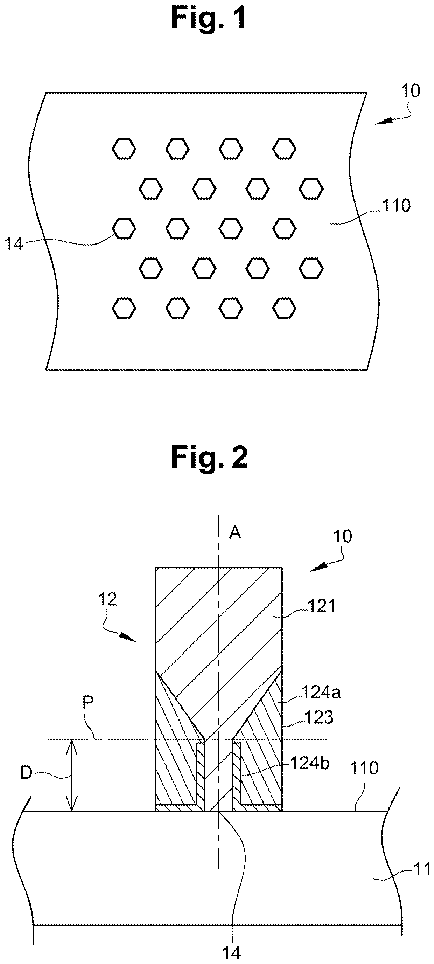

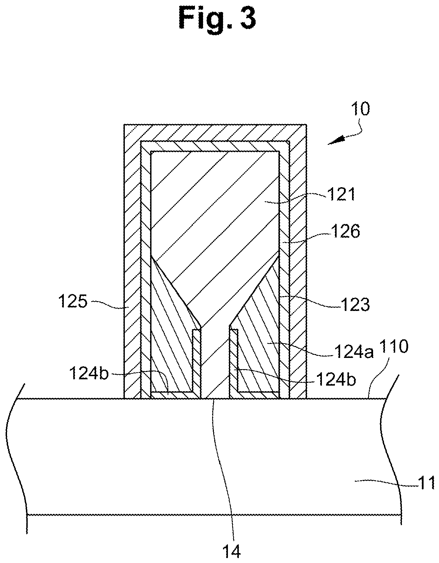

Les diodes électroluminescentes 12 décrites dans la présente invention sont agencées par exemple comme cela est représenté sur les figures 2 et 3, en étant de forme filaire et formées sur la face support 110 pour être allongée suivant un axe longitudinal A sensiblement transversal à la face support 110 du substrat 11. Les diodes électroluminescentes 12 sont préférentiellement tridimensionnelles, selon des dimensions micrométriques ou nanométriques.

Chaque diode électroluminescente 12 comprend une première zone dopée formée sur la face support 110 par des éléments semi-conducteurs dopés selon un premier type de dopage. Par « former sur » on entend soit que la diode électroluminescente 12 est formée directement sur la face support 110 moyennant un contact, soit indirectement en prévoyant l'interposition d'au moins une couche intermédiaire, comme par exemple une couche de passivation ou de nucléation ou une couche d'isolation électrique.

La première zone dopée est constituée, sur tout ou partie de sa hauteur comptée suivant l'axe longitudinal A, d'une première portion 121 centrale sensiblement allongée suivant l'axe longitudinal A. La première portion 121 est formée préférentiellement dans un premier matériau à base de nitrure de gallium. La première zone dopée est constituée en outre d'une seconde portion 123 externe formée dans un second matériau préférentiellement à base de nitrure de gallium et d'aluminium. Avantageusement, le premier matériau et le second matériau ont des paramètres de maille atomique proches ce qui permet de les associer par épitaxie par exemple en limitant les contraintes.

La seconde portion 123 est constituée d'une première partie 124a externe agencée latéralement autour de la première portion 121. Avantageusement, cet agencement permet de limiter les fuites de courant car le second matériau de la seconde portion 123 a une conductivité plus faible que celle du premier matériau. Tout ou partie de la première partie 124a présente une première concentration atomique moyenne en aluminium.

Dans un mode de réalisation particulier, la première concentration atomique moyenne en aluminium est comprise entre 0,5% et 15% et préférentiellement entre 0,5% et 7,5%. La première concentration atomique moyenne en aluminium induit, dans le second matériau une résistivité électrique élevée. Avantageusement, cette concentration atomique moyenne en aluminium permet de limiter les fuites de courant car le second matériau a alors une conductivité plus faible que celle du premier matériau à base de nitrure de gallium.

La seconde portion 123 est constituée d'une seconde partie 124b inférieure agencée, suivant l'axe longitudinal A, entre au moins la première partie 124a de la seconde portion 123 et le substrat 11. Egalement la seconde partie 124b peut être agencée à l'interface entre la première partie 124a de la seconde portion 123 et la première portion 121. La seconde partie 124b présente une deuxième concentration atomique moyenne en aluminium différente de la première concentration atomique moyenne. La deuxième concentration atomique moyenne en aluminium est telle que le second matériau, dans cette seconde partie 124b, est électriquement isolant. Dans un exemple, ladite seconde portion 123 est agencée avantageusement au moins en partie latéralement autour de la première portion 121 de façon à entourer au moins une partie de la première portion 121 à la façon d'une gaine. Ladite seconde portion 123 est formée au moins en partie de façon à être en contact avec le substrat 11. Par « en contact avec le support », on entend qu'une interface de la seconde portion 123 peut être la face libre de la couche de nucléation du substrat 11 décrite précédemment ou bien la face libre de la première couche d'isolation électrique du substrat 11 décrite précédemment.

Dans un mode de réalisation particulier, la deuxième concentration atomique moyenne en aluminium de la seconde partie 124b est comprise entre 20% et 50% et plus préférentiellement entre 25% et 35%. Avantageusement, cette deuxième concentration atomique moyenne en aluminium permet de limiter fortement les fuites de courant car le second matériau a alors un caractère isolant électriquement.

Dans un mode de réalisation particulier, ledit second matériau présente la deuxième concentration atomique moyenne au niveau de tout ou partie de son interface avec le premier matériau. La deuxième concentration atomique moyenne en aluminium peut également être présente à l'interface entre la face support 110 du substrat 11 et la partie du second matériau ayant la première concentration atomique moyenne en aluminium. Avantageusement, cette configuration permet de limiter les fuites de courant entre par exemple la première zone dopée et la deuxième zone dopée décrite plus en profondeur ci-après. Cette configuration permet également de se passer d'une isolation électrique externe à la diode électroluminescente 12 qui est coûteuse et fastidieuse. Par « isolant électrique », on entend que le second matériau, à l'endroit où il présente une deuxième concentration atomique moyenne en aluminium, a une résistivité élevée. Avantageusement, cela permet également une passivation du premier matériau de la première portion 121 vis-à-vis de l'extérieur puisque le second matériau entoure au moins en partie le premier matériau latéralement. Cela permet également de limiter la fuite de courant et de créer une passivation entre le premier matériau et les faces extérieures de la diode électroluminescente 12.

Dans un mode de réalisation particulier, le rapport entre la section de la première partie 124a de la seconde portion 123, prise dans un plan P perpendiculaire à l'axe longitudinal A et positionné à une distance D par rapport à la face support 110, et la section de la première portion 121 prise dans ledit plan P, diminue lorsque D augmente. Cette configuration permet avantageusement de privilégier la présence du second matériau au niveau où la distance D est faible ce qui est l'endroit le plus vulnérable aux fuites de courant. Dans un exemple, la première concentration atomique moyenne en aluminium correspond à des concentrations atomiques en aluminium ponctuelles prises en différents points de la première partie 124a. Les concentrations atomiques en aluminium ponctuelles peuvent varier dans le plan P et selon la distance D par exemple en suivant un gradient de concentration. Avantageusement, dans les parties de la première zone dopée où la distance D est plus élevée, le second matériau n'est pas présent ce qui préserve l'efficacité du courant allant de la première zone dopée à la zone active décrite ci-après.

La diode électroluminescente 12 comprend également une zone active 126 formée dans un matériau actif. La zone active 126 est la partie depuis laquelle est émise la majorité du rayonnement fourni par la diode électroluminescente 12. Elle peut comporter des moyens de confinement des porteurs de charge électrique, tels que des puits quantiques. Elle est, par exemple, constituée d'une alternance de couches de GaN et d'InGaN. Les couches de GaN peuvent être dopées. Alternativement, la zone active 126 est constituée par une unique couche d'InGaN.

La diode électroluminescente 12 comprend en outre une seconde zone dopée 125 formée par des éléments semi-conducteurs dopés selon un deuxième type de dopage opposé au premier type de dopage.

Préférentiellement, les éléments semiconducteurs des diodes électroluminescentes 12 tels que sont la première portion 121 ou la seconde portion 123 ou la seconde zone dopée 125 présentent une forme sensiblement filaire, conique ou tronconique. Dans le texte, les termes « élément de diode électroluminescente » font référence à la première portion 121 et/ou à la seconde portion 123 et/ou à la seconde zone dopée 125 et/ou à la zone active 126 ainsi que l'ensemble de ces différentes zones ou portions.

Dans la suite de la description et sur les figures, les modes de réalisation sont décrits pour des diodes électroluminescentes 12 tridimensionnelles de type coeur-coquille comme montrées sur la figure 3. Le coeur est constitué par les premières et deuxièmes portions 121 et 123. La coquille est formée par la zone active 126 recouverte de la seconde zone dopée 125. Toutefois, ces modes de réalisation peuvent indifféremment être mis en oeuvre pour des diodes électroluminescentes 12 tridimensionnelles présentant une structure axiale où la seconde portion 123, la première portion 121, la zone active 126 et la seconde zone dopée 125 sont empilées selon une direction transversale au plan du substrat 11. Autrement dit, selon un mode de réalisation, chaque diode électroluminescente 12 présente une structure coeur-coquille dans laquelle la première zone dopée constitue un noyau filaire dont la partie sommitale et les bordures latérales sont au moins partiellement recouvertes par une coque elle-même comprenant l'empilement d'au moins une couche formant la zone active et d'au moins une couche formant la seconde zone dopée. Alternativement dans un autre mode de réalisation non représenté, chaque diode électroluminescente 12 présente une structure axiale où la première zone dopée 121, la zone active 126 et la seconde zone dopée 125 sont respectivement empilées le long de l'axe longitudinal A.

De manière générale les différentes éléments constituant les diodes électroluminescentes 12 peuvent être obtenus par toute technique de l'homme du métier comme par exemple : un dépôt chimique en phase vapeur (CVD) sigle anglais pour chemical Layer déposition, un dépôt de couche atomique (ALD) sigle anglais pour Atomic Layer Deposition, ou dépôt physique en phase vapeur (PVD) sigle anglais pour Physical Vapor Deposition ou encore par épitaxie (par exemple MBE pour molecular beam epitaxy selon l'expression anglaise consacrée) ou encore métal organic vapor epitaxy selon l'expression anglaise consacrée (MOVPE).

La première zone dopée peut être dopée P si la seconde zone dopée est dopée N mais la première zone dopée sera préférentiellement dopée N et la seconde zone dopée 125 dopée P. Le premier matériau peut être dopé pour former une première partie d'une jonction PN ou PIN. Avantageusement la première zone dopée est dopée N.

A titre d'exemple, les éléments de diodes électroluminescentes 12 peuvent être, au moins en partie, formés à partir de matériaux semiconducteurs de groupe IV comme du silicium ou du germanium ou bien comportant majoritairement un composé III-V, par exemple des composés III-N. Des exemples du groupe III comprennent le gallium, l'indium ou l'aluminium. Des exemples de composés III-N sont GaN, AIN, InGaN ou InAIGaN ou AIGaN. D'autres éléments du groupe V peuvent également être utilisés, par exemple, le phosphore, l'arsenic ou l'antimoine. De façon générale, les éléments dans le composé III-V peuvent être combinés avec différentes fractions molaires. Il convient de préciser que les éléments de diodes électroluminescentes 12 peuvent indifféremment être formés à partir de matériaux semiconducteurs comportant majoritairement un composé II-VI. Le dopant peut être choisi, dans le cas d'un composé III-V, parmi le groupe comprenant un dopant de type P du groupe II, par exemple du magnésium, du zinc, du cadmium ou du mercure, un dopant du type P du groupe IV par exemple du carbone, ou un dopant de type N du groupe IV, par exemple du silicium, du germanium, du sélénium, du souffre, du terbium ou de l'étain. Préférentiellement la première portion 121 est en contact avec au moins une des parties composant le substrat 11.

Dans un exemple, la première portion 121 et la seconde portion 123 sont obtenues au moins en partie dans le même temps préférentiellement par épitaxie en utilisant au moins un premier gaz contenant du gallium (par exemple du TMGa pour Triméthylgallium) avec un débit compris entre 500 et 1000 sccm (pour standard centimètre cube par minute), au moins un deuxième gaz contenant de l'aluminium (par exemple : TMAI pour triméthylaluminium) avec un débit compris entre 800 et 1200 sccm et au moins un troisième gaz contenant du silane SiH₄ avec un débit compris entre 50 et 200 sccm . La température utilisée pour la formation de la première portion 121 et de la seconde portion 123 est comprise entre 900°C et 1100°C et plus préférentiellement entre 950 et 1050 °C.

Dans un mode de réalisation, la première portion 121 et la seconde portion 123 sont obtenues dans le même temps par une première phase de ségrégation entre le premier matériau et le deuxième matériau. Dans un autre mode de réalisation, une deuxième phase de ségrégation permet d'obtenir une première concentration atomique moyenne en aluminium et une deuxième concentration atomique moyenne en aluminium dans le second matériau. Les deux phases de ségrégation peuvent avoir lieu préférentiellement en même temps. Le recours à des phases de ségrégation pour obtenir une ou des parties plus résistives ou isolantes d'un matériau est avantageux car cela ne requiert aucune opération additionnelle.

Une troisième partie de la diode électroluminescente 12 peut être constituée par la seconde zone dopée 125. La seconde zone dopée 125 peut être dopée selon un deuxième type de dopage préférentiellement P. Elle peut être formée directement ou indirectement sur les interfaces libres de la zone active 126. Une fois la seconde zone dopée 125 formée, la diode électroluminescente 12 est apte à émettre de la lumière sous une excitation électrique.

L'invention porte également sur la mise en oeuvre d'un procédé de fabrication d'un dispositif optoélectronique 10 selon l'invention comme décrit ci-dessus. Le procédé de fabrication comprend les étapes suivantes :
a) fourniture du substrat 11 ayant une face support 110, ledit axe longitudinal A étant destiné à être sensiblement transversal à ladite face support 110 ;
b) formation, au niveau de ladite face support 110, d'une pluralité de zones 14 chacune étant propice à la formation ultérieure d'au moins l'une des diodes électroluminescentes 12 ;
c) formation de la première zone dopée de chaque diode électroluminescente 12 au niveau de la zone 14 correspondante. L'étape c) est réalisée de telle manière qu'à l'issue de l'étape c), la première zone dopée est constituée, sur tout ou partie de sa hauteur comptée suivant l'axe longitudinal A, d'une part d'une première portion 121 centrale sensiblement allongée suivant l'axe longitudinal A. La première portion 121 est formée dans un premier matériau à base de nitrure de gallium. La première zone dopée est constituée d'autre part d'une seconde portion 123 externe formée dans un second matériau à base de nitrure de gallium et d'aluminium. La seconde portion 123 est constituée d'une première partie 124a externe agencée latéralement autour de la première portion 121. Tout ou partie de la première partie 124a présente une première concentration atomique moyenne en aluminium. La seconde portion 123 est constituée en outre d'une seconde partie 124b inférieure agencée, suivant l'axe longitudinal, entre au moins la première partie 124a de la seconde portion 123 et le substrat 11. Tout ou partie de la seconde partie 124b présente une deuxième concentration atomique moyenne en aluminium différente de la première concentration atomique moyenne. Comme décrit précédemment, la deuxième concentration atomique moyenne en aluminium est adaptée de sorte que la seconde partie 124b est électriquement isolante ;
d) formation de la zone active 126 de chaque diode électroluminescente 12 ;
e) formation de la seconde zone dopée 125 de chaque diode électroluminescentes 12.

Selon un mode de réalisation du procédé de fabrication, l'étape c) est réalisée parépitaxie en utilisant au moins en partie un premier gaz contenant du gallium et un deuxième gaz contenant de l'aluminium et un troisième gaz contenant du silicium tel que le silane SiH₄. L'intérêt d'utiliser du silane SiH₄ est de favoriser la croissance verticale plutôt qu'horizontale.

Selon un autre mode de réalisation du procédé de fabrication, l'étape c) est réalisée dans une enceinte dans laquelle règne une température comprise entre 900°C et 1100°C et de préférence entre 950°C et 1000°C.

Selon un autre mode de réalisation du procédé de fabrication, la première partie 124a de la seconde portion 123, et la seconde partie 124b de la seconde portion 123 sont obtenues par une première phase de ségrégation lors de l'étape c).

Selon un mode de réalisation du procédé de fabrication, la première concentration atomique moyenne en aluminium est comprise entre 0,5% et 15% et préférentiellement entre 0,5% et 7,5% et la deuxième concentration atomique moyenne en aluminium est comprise entre 20% et 50% et plus préférentiellement entre 25% et 35%.

Selon un autre mode de réalisation du procédé de fabrication, l'étape c) comprend une deuxième phase de ségrégation de sorte qu'après la deuxième phase de ségrégation, le rapport entre la section de la première partie 124a de la seconde portion 123, prise dans un plan P perpendiculaire à l'axe longitudinal A et positionné à une distance D par rapport à la face support 110, et la section de la première portion 121 prise dans ledit plan P, diminue lorsque D augmente. Cela permet avantageusement d'obtenir un matériau isolant naturellement placé entre la première portion 121 et la deuxième zone dopée 125 ce qui évite des étapes coûteuses pour limiter les fuites de courant entre ces deux entités. Cela permet également de passiver la première portion 121 car la seconde portion 123 l'entoure en partie vis-à-vis de l'extérieur. Dans un exemple, la première concentration atomique moyenne en aluminium correspond à des concentrations atomiques en aluminium qui seraient mesurées en différents points de la première partie 124a et ainsi dénommées concentrations ponctuelles. Les concentrations atomiques en aluminium ponctuelles peuvent ainsi varier dans le plan P et selon la distance D par exemple en suivant un gradient de concentration atomique.

Selon un autre mode de réalisation du procédé de fabrication, la première phase de ségrégation et la deuxième phase de ségrégation sont réalisées au moins en partie en même temps. Ceci permet avantageusement de réduire le nombre d'étapes pour isoler électriquement la première zone dopée et la deuxième zone dopée vis-à-vis de courants de fuites.

Selon un autre mode de réalisation du procédé de fabrication, lors de l'étape c), le premier gaz (par exemple du TMGa) est injecté avec un débit compris entre 200 et 600 sccm, de préférence 400 sccm, le deuxième gaz contenant de l'aluminium est injecté avec un débit compris entre 1000 et 2000 sccm et le troisième gaz le silane SiH₄ est injecté avec un débit compris entre 400 et 800 sccm de préférence 600 sccm.

Selon un autre mode de réalisation du procédé de fabrication, la première phase de ségrégation est réalisée de telle façon que le second matériau présente la deuxième concentration atomique moyenne au niveau de tout ou partie de son interface avec le premier matériau. Cela permet avantageusement que par exemple, une partie de la première portion 121 et que l'interface entre la deuxième portion 123 et le substrat soient isolés électriquement du substrat. Ceci limite ainsi les courants de fuite.

## Revendications

1. Dispositif optoélectronique (10) comportant un substrat (11) ayant une face support (110) et une pluralité de diodes électroluminescentes (12), chacune étant de forme filaire et formée sur la face support (110) pour être allongée suivant un axe longitudinal (A) sensiblement transversal à la face support (110) du substrat (11), chaque diode électroluminescente (12) comprenant une première zone dopée formée sur la face support (110) par des éléments semi-conducteurs dopés selon un premier type de dopage, une zone active (126) formée dans un matériau actif et une seconde zone dopée (125) formée par des éléments semi-conducteurs dopés selon un deuxième type de dopage opposé au premier type de dopage, la première zone dopée étant constituée, sur tout ou partie de sa hauteur comptée suivant l'axe longitudinal (A), d'une première portion (121) centrale sensiblement allongée suivant l'axe longitudinal (A) formée dans un premier matériau à base de nitrure de gallium et d'une seconde portion (123) externe formée dans un second matériau à base de nitrure de gallium et d'aluminium, la seconde portion (123) étant constituée d'une première partie (124a) externe agencée latéralement autour de la première portion (121), tout ou partie de la première partie (124a) présentant une première concentration atomique moyenne en aluminium et d'une seconde partie (124b) inférieure agencée, suivant l'axe longitudinal (A), au moins entre la première partie (124a) de la seconde portion (123) et le substrat (11), tout ou partie de la seconde partie (124b) présentant une deuxième concentration atomique moyenne en aluminium différente de la première concentration atomique moyenne et adaptée de sorte que la seconde partie (124b) est électriquement isolante.

2. Dispositif optoélectronique (10) selon la revendication 1, **caractérisé en ce que** le rapport entre la section de la première partie (124a) de la seconde portion (123), prise dans un plan (P) perpendiculaire à l'axe longitudinal (A) et positionné à une distance (D) par rapport à la face support (110), et la section de la première portion (121) prise dans ledit plan (P), diminue lorsque la distance (D) augmente.

3. Dispositif optoélectronique (10) selon la revendication 2, **caractérisé en ce que** la première concentration atomique moyenne en aluminium correspond à des concentrations atomiques en aluminium ponctuelles prises en différents points de la première partie (124a), les concentrations atomiques en aluminium ponctuelles pouvant varier dans le plan (P) et selon la distance (D).

4. Dispositif optoélectronique (10) selon l'une des revendications 1 à 3, **caractérisé en ce que** la première concentration atomique moyenne en aluminium est comprise entre 0,5% et 15% et la deuxième concentration atomique moyenne en aluminium est comprise entre 20% et 50%.

5. Dispositif optoélectronique (10) selon l'une des revendications 1 à 4, **caractérisé en ce que** ledit second matériau présente la deuxième concentration atomique moyenne au niveau de tout ou partie de son interface avec le premier matériau.

6. Procédé de fabrication d'un dispositif optoélectronique (10) comportant une pluralité de diodes électroluminescentes (12) où chacune est de forme filaire allongée suivant un axe longitudinal (A) et comprend une première zone dopée formée sur la face support (110) par des éléments semi-conducteurs dopés selon un premier type de dopage, une zone active (126) formée dans un matériau actif et une seconde zone dopée (125) formée par des éléments semi-conducteurs dopés selon un deuxième type de dopage opposé au premier type de dopage, le procédé comprenant les étapes suivantes :
a) fourniture d'un substrat (11) ayant une face support (110), ledit axe longitudinal (A) étant destiné à être sensiblement transversal à ladite face support (110) ;
b) formation, au niveau de ladite face support (110), d'une pluralité de zones (14) chacune étant propice à la formation ultérieure d'au moins l'une des diodes électroluminescentes (12) ;
c) formation de la première zone dopée de chaque diode électroluminescente (12) au niveau de la zone (14) correspondante, l'étape c) étant réalisée de telle manière qu'à l'issue de l'étape c), la première zone dopée est constituée, sur tout ou partie de sa hauteur comptée suivant l'axe longitudinal (A), d'une part d'une première portion (121) centrale sensiblement allongée suivant l'axe longitudinal (A) formée dans un premier matériau à base de nitrure de gallium, et d'autre part d'une seconde portion (123) externe formée dans un second matériau à base de nitrure de gallium et d'aluminium, la seconde portion (123) étant constituée d'une première partie (124a) externe agencée latéralement autour de la première portion (121), tout ou partie de la première partie (124a) présentant une première concentration atomique moyenne en aluminium et d'une seconde partie (124b) inférieure agencée, suivant l'axe longitudinal (A), entre au moins la première partie (124a) de la seconde portion (123) et le substrat (11), tout ou partie de la seconde partie (124b) présentant une deuxième concentration atomique moyenne en aluminium différente de la première concentration atomique moyenne et adaptée de sorte que la seconde partie (124b) est électriquement isolante ;
d) formation de la zone active (126) de chaque diode électroluminescente (12) ;
e) formation de la seconde zone dopée (125) de chaque diode électroluminescentes (12).

7. Procédé de fabrication selon la revendication 6, caratérisé en ce que l'étape c) est réalisée par épitaxie en utilisant au moins en partie un premier gaz contenant du gallium et un deuxième gaz contenant de l'aluminium et un troisième gaz contenant du silane SiH₄.

8. Procédé de fabrication selon l'une des revendications 6 à 7, caratérisé en ce que l'étape c) est réalisée dans une enceinte dans laquelle règne une température comprise entre 900 et 1100 °C.

9. Procédé de fabrication selon l'une des revendications 6 à 8, caratérisé en ce que la première partie (124a) de la seconde portion (123), et la seconde partie (124b) de la seconde portion (123) sont obtenues par une première phase de ségrégation lors de l'étape c).

10. Procédé de fabrication selon l'une des revendications 6 à 9, **caractérisé en ce que** la première concentration atomique moyenne en aluminium est comprise entre 0,5% et 15% et la deuxième concentration atomique moyenne en aluminium est comprise entre 20% et 50%.

11. Procédé de fabrication selon l'une des revendications 6 à 10, **caractérisé en ce que** l'étape c) comprend une deuxième phase de ségrégation de sorte qu'après la deuxième phase de ségrégation, le rapport entre la section de la première partie (124a) de la seconde portion (123), prise dans un plan (P) perpendiculaire à l'axe longitudinal (A) et positionné à une distance (D) par rapport à la face support (110), et la section de la première portion (121) prise dans ledit plan (P), diminue lorsque la distance (D) augmente.

12. Procédé de fabrication selon la revendication 11, **caractérisé en ce que** la première concentration atomique moyenne en aluminium correspond à des concentrations atomiques en aluminium ponctuelles prises en différents points de la première partie (124a), les concentrations atomiques en aluminium ponctuelles pouvant varier dans le plan (P) et selon la distance (D).

13. Procédé de fabrication selon l'une des revendications 11 ou 12, **caractérisé en ce que** la première phase de ségrégation et la deuxième phase de ségrégation sont réalisées au moins en partie en même temps.

14. Procédé de fabrication selon l'une des revendications 7 à 13, **caractérisé en ce que** lors de l'étape c) le deuxième gaz contenant de l'aluminium est injecté avec un débit compris entre 1000 et 2000 sccm et le troisième gaz contenant du silane SiH₄ est injecté avec un débit compris entre 400 et 800 sccm.

15. Procédé de fabrication selon l'une des revendications 9 à 14, **caractérisé en ce que** la première phase de ségrégation est réalisée de telle façon que le second matériau présente la deuxième concentration atomique moyenne au niveau de tout ou partie de son interface avec le premier matériau.

## Patentansprüche

1. Optoelektronische Vorrichtung (10), umfassend ein Substrat (11) mit einer Tragefläche (110) und einer Vielzahl von Elektrolumineszenzdioden (12), wobei jede drahtförmig ist und auf der Tragefläche (110) gebildet ist, um entlang einer Längsachse (A), die im Wesentlichen quer zu der Tragefläche (110) des Substrats (11) ist, länglich zu sein, wobei jede Elektrolumineszenzdiode (12) eine erste dotierte Zone, die auf der Tragefläche (110) von Halbleiterelementen, die gemäß einem ersten Dotierungstyp dotiert sind, gebildet wird, eine aktive Zone (126), die in einem aktiven Material gebildet ist, und eine zweite dotierte Zone (125) umfasst, die von Halbleiterelementen, die gemäß einem zweiten Dotierungstyp, der entgegengesetzt zu dem ersten Dotierungstyp ist, dotiert sind, gebildet wird, wobei die erste dotierte Zone auf ihrer gesamten oder einem Teil ihrer Höhe, gerechnet entlang der Längsachse (A), aus einem ersten, zentralen Abschnitt (121), der im Wesentlichen entlang der Längsachse (A) länglich ist und in einem ersten Material auf der Basis von Galliumnitrid gebildet ist, und einem zweiten, externen Abschnitt (123) besteht, der in einem zweiten Material auf der Basis von Gallium- und Aluminiumnitrid gebildet ist, wobei der zweite Abschnitt (123) aus einem ersten, externen Teil (124a), der seitlich um den ersten Abschnitt (121) angeordnet ist, wobei der gesamte oder ein Teil des ersten Teils (124a) eine erste durchschnittliche Atomkonzentration von Aluminium aufweist, und einem zweiten, unteren Teil (124b) besteht, der entlang der Längsachse (A) mindestens zwischen dem ersten Teil (124a) des zweiten Abschnitts (123) und dem Substrat (11) angeordnet ist, wobei der gesamte oder ein Teil des zweiten Teils (124b) eine zweite durchschnittliche Atomkonzentration von Aluminium, die sich von der ersten durchschnittlichen Atomkonzentration unterscheidet, aufweist und derart eingerichtet ist, dass der zweite Teil (124b) elektrisch isolierend ist.

2. Optoelektronische Vorrichtung (10) nach Anspruch 1, **dadurch gekennzeichnet, dass** das Verhältnis zwischen dem Teilabschnitt des ersten Teils (124a) des zweiten Abschnitts (123), genommen in einer Ebene (P), die senkrecht zu der Längsachse (A) ist, und positioniert in einem Abstand (D) in Bezug auf die Tragefläche (110), und dem Teilabschnitt des ersten Abschnitts (121), genommen in der Ebene (P), abnimmt, wenn der Abstand (D) zunimmt.

3. Optoelektronische Vorrichtung (10) nach Anspruch 2, **dadurch gekennzeichnet, dass** die erste durchschnittliche Atomkonzentration von Aluminium punktuellen durchschnittlichen Atomkonzentrationen von Aluminium, genommen an unterschiedlichen Punkten des ersten Teils (124a), entspricht, wobei die punktuellen durchschnittlichen Atomkonzentrationen in der Ebene (P) und gemäß dem Abstand (D) variieren können.

4. Optoelektronische Vorrichtung (10) nach einem der Ansprüche 1 bis 3, **dadurch gekennzeichnet, dass** die erste durchschnittliche Atomkonzentration von Aluminium zwischen 0,5 % und 15 % liegt und die zweite durchschnittliche Atomkonzentration von Aluminium zwischen 20 % und 50 % liegt.

5. Optoelektronische Vorrichtung (10) nach einem der Ansprüche 1 bis 4, **dadurch gekennzeichnet, dass** das zweite Material die zweite durchschnittliche Atomkonzentration auf Höhe seiner gesamten oder eines Teils seiner Grenzfläche mit dem ersten Material aufweist.

6. Verfahren zur Herstellung einer optoelektronischen Vorrichtung (10), umfassend die Vielzahl von Elektrolumineszenzdioden (12), wo jede drahtförmig, entlang einer Längsachse (A) länglich ist und eine erste dotierte Zone, die auf der Tragefläche (110) von Halbleiterelementen, die gemäß einem ersten Dotierungstyp dotiert sind, gebildet wird, eine aktive Zone (126), die in einem aktiven Material gebildet ist, und eine zweite dotierte Zone (125) umfasst, die von Halbleiterelementen, die gemäß einem zweiten Dotierungstyp, der entgegengesetzt zu dem ersten Dotierungstyp ist, dotiert sind, gebildet wird, wobei das Verfahren die folgenden Schritte umfasst:
a) Bereitstellen eines Substrats (11) mit einer Tragefläche (110), wobei die Längsachse (A) dazu vorgesehen ist, im Wesentlichen quer zu der Tragefläche (110) zu sein;
b) Bilden einer Vielzahl von Zonen (14) auf Höhe der Tragefläche (110), wobei jede für die spätere Bildung mindestens einer der Elektrolumineszenzdioden (12) geeignet ist;
c) Bilden der ersten dotierten Zone jeder Elektrolumineszenzdiode (12) auf Höhe der entsprechenden Zone (14), wobei der Schritt c) so durchgeführt wird, dass zum Ende des Schritts c) die erste dotierte Zone auf ihrer gesamten oder einem Teil ihrer Höhe, gerechnet entlang der Längsachse (A), aus einerseits einem ersten, zentralen Abschnitt (121), der im Wesentlichen entlang der Längsachse (A) länglich ist und in einem ersten Material auf der Basis von Galliumnitrid gebildet ist, und andererseits einem zweiten, externen Abschnitt (123) besteht, der in einem zweiten Material auf der Basis von Gallium- und Aluminiumnitrid gebildet ist, wobei der zweite Abschnitt (123) aus einem ersten, externen Teil (124a), der seitlich um den ersten Abschnitt (121) angeordnet ist, wobei der gesamte oder ein Teil des ersten Teils (124a) eine erste durchschnittliche Atomkonzentration von Aluminium aufweist, und einem zweiten, unteren Teil (124b) besteht, der entlang der Längsachse (A) zwischen mindestens dem ersten Teil (124a) des zweiten Abschnitts (123) und dem Substrat (11) angeordnet ist, wobei der gesamte oder ein Teil des zweiten Teils (124b) eine zweite durchschnittliche Atomkonzentration von Aluminium, die sich von der ersten durchschnittlichen Atomkonzentration unterscheidet, aufweist und derart eingerichtet ist, dass der zweite Teil (124b) elektrisch isolierend ist;
d) Bilden der aktiven Zone (126) jeder Elektrolumineszenzdiode (12);
e) Bilden der zweiten dotierten Zone (125) jeder Elektrolumineszenzdiode (12).

7. Herstellungsverfahren nach Anspruch 6, **dadurch gekennzeichnet, dass** der Schritt c) mittels Epitaxie durchgeführt wird, indem mindestens zum Teil ein erstes Gas, das Gallium enthält, und ein zweites Gas, das Aluminium enthält, und ein drittes Gas, das Silan SiH₄ enthält, verwendet wird.

8. Herstellungsverfahren nach einem der Ansprüche 6 bis 7, **dadurch gekennzeichnet, dass** der Schritt c) in einem Gehäuse durchgeführt wird, in dem eine Temperatur herrscht, die zwischen 900 und 1100 °C liegt.

9. Herstellungsverfahren nach einem der Ansprüche 6 bis 8, **dadurch gekennzeichnet, dass** der erste Teil (124a) des zweiten Abschnitts (123) und der zweite Teil (124b) des zweiten Abschnitts (123) durch eine erste Entmischungsphase während des Schritts c) erhalten werden.

10. Herstellungsverfahren nach einem der Ansprüche 6 bis 9, **dadurch gekennzeichnet, dass** die erste durchschnittliche Atomkonzentration von Aluminium zwischen 0,5 % und 15 % liegt und die zweite durchschnittliche Atomkonzentration von Aluminium zwischen 20 % und 50 % liegt.

11. Herstellungsverfahren nach einem der Ansprüche 6 bis 10, **dadurch gekennzeichnet, dass** der Schritt c) eine zweite Entmischungsphase umfasst, so dass nach der zweiten Entmischungsphase das Verhältnis zwischen dem Teilabschnitt des ersten Teils (124a) des zweiten Abschnitts (123), genommen in einer Ebene (P), die senkrecht zu der Längsachse (A) ist, und positioniert in einem Abstand (D) in Bezug auf die Tragefläche (110), und dem Teilabschnitt des ersten Abschnitts (121), genommen in der Ebene (P), abnimmt, wenn der Abstand (D) zunimmt.

12. Herstellungsverfahren nach Anspruch 11, **dadurch gekennzeichnet, dass** die erste durchschnittliche Atomkonzentration von Aluminium punktuellen durchschnittlichen Atomkonzentrationen von Aluminium, genommen an unterschiedlichen Punkten des ersten Teils (124a), entspricht, wobei die punktuellen durchschnittlichen Atomkonzentrationen in der Ebene (P) und gemäß dem Abstand (D) variieren können.

13. Herstellungsverfahren nach einem der Ansprüche 11 oder 12, **dadurch gekennzeichnet, dass** die erste Entmischungsphase und die zweite Entmischungsphase mindestens zum Teil zeitgleich durchgeführt werden.

14. Herstellungsverfahren nach einem der Ansprüche 7 bis 13, **dadurch gekennzeichnet, dass** während des Schritts c) das zweite Gas, das Aluminium enthält, mit einem Durchsatz injiziert wird, der zwischen 1000 und 2000 sccm liegt, und das dritte Gas, das Silan SiH₄ enthält, mit einem Durchsatz injiziert wird, der zwischen 400 und 800 sccm liegt.

15. Herstellungsverfahren nach einem der Ansprüche 9 bis 14, **dadurch gekennzeichnet, dass** die erste Entmischungsphase derart durchgeführt wird, dass das zweite Material die zweite durchschnittliche Atomkonzentration von Aluminium auf Höhe seiner gesamten oder eines Teils einer Grenzfläche mit dem ersten Material aufweist.

## Claims

1. An optoelectronic device (10) including a substrate (11) having a support face (110) and a plurality of light-emitting diodes (12), each being wire-shaped and formed on the support face (110) so as to be elongate along a longitudinal axis (A) substantially transverse to the support face (110) of the substrate (11), each light-emitting diode (12) comprising a first doped area formed on the support face (110) by semiconductor elements doped according to a first doping type, an active area (126) formed of an active material and a second doped area (125) formed by semiconductor elements doped according to a second doping type opposite to the first doping type, the first doped area being constituted, over all or part of its height, counted along the longitudinal axis (A), of a first central portion (121) substantially elongate along the longitudinal axis (A) formed in a first material based on gallium nitride and a second outer portion (123) formed in a second material based on gallium and aluminum nitride, the second portion (123) being constituted of a first outer part (124a) laterally arranged around the first portion (121), all or part of the first part (124a) having a first average atomic concentration of aluminum and of a second lower part (124b) arranged, along the longitudinal axis (A), at least between the first part (124a) of the second portion (123) and the substrate (11), all or part of the second part (124b) having a second average atomic concentration of aluminum different from the first average atomic concentration and adapted so that the second part (124b) is electrically insulating.

2. The optoelectronic device (10) according to claim 1, **characterized in that** the ratio between the section of the first part (124a) of the second portion (123), considered in a plane (P) perpendicular to the longitudinal axis (A) and positioned at a distance (D) relative to the support face (110), and the section of the first portion (121) considered in said plane (P), decreases when the distance (D) increases.

3. The optoelectronic device (10) according to claim 2, **characterized in that** the first average atomic concentration of aluminum corresponds to point atomic concentrations of aluminum considered at different points of the first part (124a), the point atomic concentrations of aluminum could vary in the plane (P) and according to the distance (D).

4. The optoelectronic device (10) according to any of claims 1 to 3, **characterized in that** the first average atomic concentration of aluminum is comprised between 0.5% and 15% and the second average atomic concentration of aluminum is comprised between 20% and 50%.

5. The optoelectronic device (10) according to any of claims 1 to 4, **characterized in that** said second material has the second average atomic concentration at all or part of its interface with the first material.

6. A method for manufacturing an optoelectronic device (10) including a plurality of light-emitting diodes (12) where each has an elongate wire shape along a longitudinal axis (A) and comprises a first doped area formed on the support face (110) by semiconductor elements doped according to a first doping type, an active area (126) formed in an active material and a second doped area (125) formed by semiconductor elements doped according to a second doping type opposite to the first doping type, the method comprising the following steps:
a) providing a substrate (11) having a support face (110), said longitudinal axis (A) being intended to be substantially transverse to said support face (110);
b) forming, at said support face (110), a plurality of areas (14) each being suitable for the subsequent formation of at least one of the light-emitting diodes (12);
c) forming the first doped area of each light-emitting diode (12) at the corresponding area (14), step c) being carried out in such a way that at the end of step c), the first doped area consists, over all or part of its height counted along the longitudinal axis (A), on the one hand of a first central portion (121) substantially elongate along the longitudinal axis (A) formed in a first material based on gallium nitride, and on the other hand of a second outer portion (123) formed in a second material based on gallium and aluminum nitride, the second portion (123) consisting of a first outer part (124a) arranged laterally around the first portion (121), all or part of the first part (124a) having a first average atomic concentration of aluminum and a second lower part (124b) arranged, along the longitudinal axis (A), between at least the first part (124a) of the second portion (123) and the substrate (11), all or part of the second part (124b) having a second average atomic concentration of aluminum different from the first average atomic concentration and adapted so that the second part (124b) is electrically insulating;
d) forming the active area (126) of each light-emitting diode (12);
e) forming the second doped area (125) of each light-emitting diode (12).

7. The manufacturing method according to claim 6, **characterized in that** step c) is carried out by epitaxy using at least partially a first gas containing gallium and a second gas containing aluminum and a third gas containing silane SiH₄.

8. The manufacturing method according to any of claims 6 to 7, **characterized in that** step c) is carried out in an enclosure in which a temperature comprised between 900 and 1100°C prevails.

9. The manufacturing method according to any of claims 6 to 8, **characterized in that** the first part (124a) of the second portion (123), and the second part (124b) of the second portion (123) are obtained by a first segregation phase during step c).

10. The manufacturing method according to any of claims 6 to 9, **characterized in that** the first average atomic concentration of aluminum is comprised between 0.5% and 15% and the second average atomic concentration of aluminum is comprised between 20% and 50%.

11. The manufacturing method according to any of claims 6 to 10, **characterized in that** step c) comprises a second segregation phase so that after the second segregation phase, the ratio between the section of the first part (124a) of the second portion (123), considered in a plane (P) perpendicular to the longitudinal axis (A) and positioned at a distance (D) from the support face (110), and the section of the first portion (121) considered in said plane (P), decreases when the distance (D) increases.

12. The manufacturing method according to claim 11, **characterized in that** the first average atomic concentration of aluminum corresponds to point atomic concentrations of aluminum considered at different points of the first part (124a), the point atomic concentrations of aluminum could vary in the plane (P) and according to the distance (D).

13. The manufacturing method according to any of claims 11 or 12, **characterized in that** the first segregation phase and the second segregation phase are carried out at least partially at the same time.

14. The manufacturing method according to any of claims 7 to 13, **characterized in that** during step c) the second gas containing aluminum is injected with a flow rate comprised between 1000 and 2000 sccm and the third gas containing silane SiH₄ is injected at a flow rate comprised between 400 and 800 sccm.

15. The manufacturing method according to any of claims 9 to 14, **characterized in that** the first segregation phase is carried out such that the second material has the second average atomic concentration at all or part of its interface with the first material.
